# FASCICULE DE BREVET EUROPEEN

(11) **EP 2 414 848 B1**
(45) Date de publication et mention de la délivrance du brevet: **05.06.2013**
(21) Numéro de dépôt: 10711690.7
(22) Date de dépôt: 30.03.2010
(51) Int. Cl.: G01R 15/18

(54) **CAPTEUR DE COURANT EN FORME D'UN CABLE A ATTACHER EN BOUCLE**
STROMSENSOR IN FORM EINES IN EINER SCHLEIFE ANZUSCHLIESSENDEN KABELS
CURRENT SENSOR IN THE FORM OF A CABLE TO BE ATTACHED IN A LOOP

(30) Priorité: 30.03.2009 FR 0951961
(43) Date de publication de la demande: 08.02.2012
(73) Titulaire: ALSTOM Technology Ltd, 5400 Baden (CH)
(72) Inventeur: JUGE, Patrice, F-74150 Marcellaz (FR); RAYON, Jean-Luc, F-69250 Montanay (FR)
(74) Mandataire: Ilgart, Jean-Christophe
(86) Numéro de dépôt international: PCT/EP2010/054237
(87) Numéro de publication internationale: WO 2010/112523

(56) Documents cités:
- EP-A- 0 652 441
- EP-A- 2 009 453
- WO-A-99/54740
- US-A- 3 434 052

## Description

Le sujet de l'invention est un capteur de courant sous forme d'un câble attaché en boucle autour d'un élément conducteur qu'il doit surveiller; l'invention concerne aussi certains appareillages électriques conçus pour recevoir ce câble ou auxquels il peut s'appliquer.

Des capteurs de courant sont utilisés sur les installations de transport de l'électricité pour mesurer certains défauts et notamment les courts-circuits au moyen de courants induits en eux par le courant circulant dans l'élément à surveiller. Les disjoncteurs aussi présents dans les installations électriques ouvrent la ligne pour interrompre le courant automatiquement à l'apparition d'un court-circuit. Une refermeture automatique de la ligne est entreprise peu de temps après pour rétablir le courant au plus vite. Elle n'est pourtant fructueuse que si le défaut à l'origine du court-circuit a été temporaire et a disparu. Si le défaut subsiste, le disjoncteur doit rouvrir la ligne, mais certains équipements comme des postes électriques à isolation gazeuse peuvent avoir été endommagés à la refermeture. C'est pourquoi l'utilisation de capteurs de courant est souhaitée pour vérifier la disparition du défaut avant la refermeture automatique et pour empêcher celle-ci dans le cas contraire.

De nombreux capteurs de courant ne sont pas efficaces pour cette application puisqu'ils se saturent sur une partie de la plage de mesure ou n'ont pas une réponse proportionnelle, ce qui les rend peu aptes à surveiller les courants élevés caractéristiques des courts-circuits. C'est notamment le cas des capteurs pourvus d'un transformateur à noyau magnétique.

Parmi les capteurs de courant dépourvus de ce défaut, on distingue ici les capteurs sous forme d'un câble à attacher en boucle autour de l'élément à surveiller, et qui comprennent un bobinage logé dans la câble et faisant office de transformateur. Ces capteurs sont fondés sur le principe de mesure de Rogowski, dont ils portent couramment le nom. Leurs modèles connus présentent toutefois certains inconvénients: il est difficile d'établir la boucle avec précision et de façon reproductible, de sorte que les caractéristiques de mesure varient en fonction de son diamètre et de l'angle de circonférence sur lequel s'étend le transformateur. Cette difficulté existe aussi bien pour les capteurs dont les extrémités sont nouées l'une à l'autre par un ruban et possèdent donc des portions se recouvrant, que pour ceux dont les extrémités sont engagées l'une en face de l'autre dans un manchon, puisque le montage est imprécis et admet un jeu non négligeable entre les extrémités du câble, qui diminue aussi la précision de la mesure. Et l'état de montage risque d'être modifié avec le temps, ce qui cause de nouvelles dérives de mesure, et rend ces capteurs délicats d'emploi pour des installations permanentes vers un appareillage.

EP-A-2 009 453 décrit un capteur de courant de type Rogowski, comprenant un mécanisme de fermeture de la boucle de courant comprenant un corps perméable magnétique s'étendant entre les extrémités de la boucle quand elle est fermée.

L'objet de l'invention est un capteur amélioré du genre précité, qui soit facile à installer à une position fixe d'un équipement électrique comme un poste électrique à isolation gazeuse ou une traversée aérienne vers une ligne aérienne de courant, et qui soit exempt de défauts de mesure dus à des incertitudes de bouclage ou des variations avec le temps.

Sous une forme générale, l'invention est relative à un capteur de courant sous forme d'un câble à attacher en boucle autour d'un élément conducteur à surveiller en joignant des extrémités du câble, le câble comprenant une gaine et un bobinage transformateur logé dans la gaine, et le capteur comprenant un manchon à perçage de réception et de raccordement des extrémités du câble, caractérisé en ce que le manchon de raccordement contient une mémoire électronique contenant des paramètres de calibration du capteur et, dans le perçage, un dispositif de fermeture et d'ouverture comportant une bague circulaire déformable assurant soit le maintien en boucle fermée du câble, soit une ouverture de la boucle grâce à un poussoir externe, apte à presser sur la bague enserrant puis dégageant une des extrémités, mobile, du câble.

La bague anti-retour située dans le manchon devant au moins une extrémité du câble (quand il est inséré dans le manchon) permet de retenir en position cette extrémité mobile du câble, ce qui garantit le maintien de la fermeture du capteur durant son utilisation même de longue durée malgré les influences auxquelles il est soumis.

Une poussée intentionnelle sur le poussoir externe peut exercer un effort sur la bague anti-retour afin d'ouvrir le capteur en phase de démontage. Un dispositif anti-retour équipe l'extrémité du câble fixe.

Selon une réalisation préférée, le bobinage du câble affleure à ses extrémités, sans interposition d'une rondelle pleine destinée à les fermer, et qui empêcherait d'établir un cercle complet du bobinage. Les extrémités sont droites en étant dépourvues de relief. Et le manchon est entièrement évidé en ayant un perçage de section constante, en tout cas dépourvu de butée. Un cercle complet de bobinage est alors obtenu par l'aboutement des extrémités droites, établi par une simple poussée manuelle. La mesure est de meilleure qualité. Aucune butée n'existant dans le manchon de réception, rien ne s'oppose à cet aboutement, et le monteur ressentant le contact des extrémités par l'effort qu'il exerce, il sait quand le bouclage du capteur est achevé, sans devoir faire quelque autre réglage ou vérification que ce soit.

Des joints situés des deux côtés du manchon et autour des deux extrémités du câble permettent de rendre étanche le capteur, ce qui est nécessaire pour de nombreuses applications.

Le corps du manchon est en matériau amagnétique, par exemple en inoxydable amagnétique ou en matière plastique, de façon à ne pas perturber la mesure de courant.

Le capteur présente la souplesse et la résistance nécessaire, avec, par exemple, une gaine comprenant une couche extérieure en polyuréthane, une couche intérieure soit en polyuréthane soit en polyamide, le bobinage étant encastré entre ces deux couches.

La gaine intérieure est d'une épaisseur suffisante pour garantir un maintien en position centrale du fil de retour, ce qui est améliore la précision.

Suivant deux modes de réalisation, le bobinage est en fil conducteur isolé par une gaine plastique ou encore par vernis.

Selon divers perfectionnement, le capteur peut comprendre un capteur de température ou un dispositif de paramétrage, ces différents moyens pouvant être logés dans une branche du manchon destinée à une connexion extérieure et perpendiculaire à deux branches principales du manchon qui reçoivent les extrémités du câble. Le capteur de température aide à accomplir des ajustements de calibrage des capteurs et le dispositif de paramétrage contient les indications caractérisant la mesure du capteur et permettant de convertir immédiatement (à température donnée) les signaux qu'il reçoit en valeurs de courant le long du conducteur à surveiller.

L'invention sera maintenant décrite en liaison aux figures suivantes:
- la figure 1 représente un exemple d'utilisation de l'invention,
- les figures 2, 3 et 4 sont trois vues du capteur de courant: la figure 2 une vue générale, la figure 3 une vue du raccordement, et la figure 4 une vue de la connexion électrique,
- et les figures 5 et 6 illustrent deux vues (en coupe axiale et coupe diamétrale) d'un appareillage recevant le capteur.

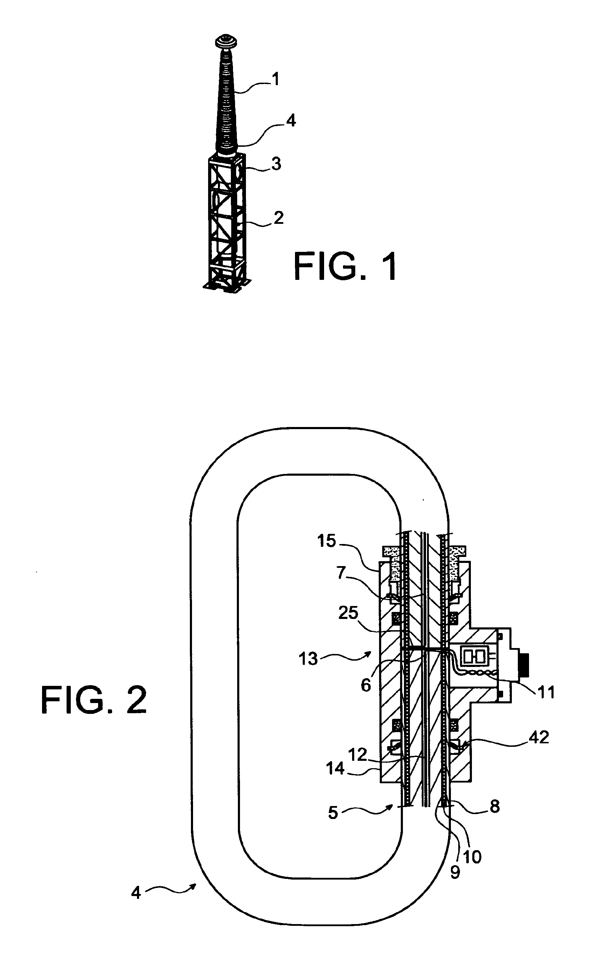

La figure 1 représente un appareillage de transport de l'électricité comprenant une traversée aérienne 1 au-dessus de laquelle se trouve une ligne aérienne électrique. Un câble électrique blindé 2 s'étend au-dessous de la traversée 1; il est muni d'un disjoncteur 3 et d'autres appareillages, comme il est connu. Un capteur de courant 4 conforme à l'invention est représentée à la base de la traversée aérienne 1, mais il pourrait être employé à d'autres endroits et notamment autour du disjoncteur 3.

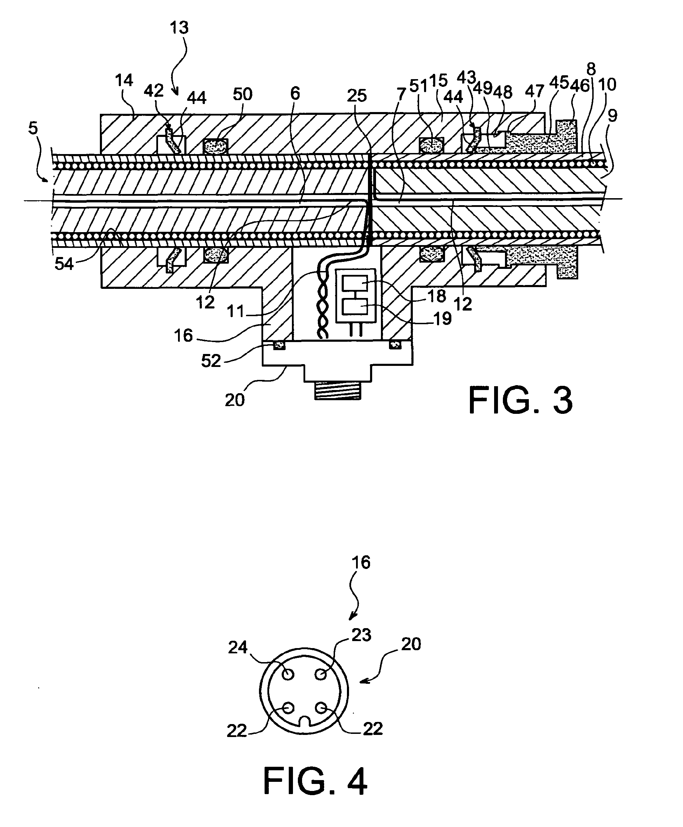

Il s'agit d'un câble 5 (figures 2 et 3) pouvant être refermé en boucle en aboutant ses extrémités l'une contre l'autre. Le câble 5 comprend une couche externe 8 de gaine, pouvant être en polyuréthane souple de 14mm de diamètre extérieur, et une couche interne 9 de gaine concentrique à la précédente et en polyuréthane ou en polyamide. Un bobinage 10 en fil conducteur, pouvant être isolé par une gaine plastique ou par un vernis est encastré entre les deux couches de gaine et s'étend sur toute la longueur du câble 5, d'une extrémité 6 à l'autre 7. Le bobinage 10 finit sur un fil d'entrée 11 quittant le câble 5 et un fil de sortie 12 s'étendant à l'intérieur de la gaine interne 9 depuis l'extrémité 7 jusqu'à l'autre extrémité 6 avant de quitter le câble 5 lui aussi. La couche interne 9 de gaine est avantageusement assez épaisse pour ne pas transmettre de déplacements importants du fils de sortie 12 et le maintenir au centre du câble 5. Le capteur 4 comprend encore un raccord 13 sous la forme d'un manchon, comprenant une première branche 14 pour loger fixement une extrémité 6, une deuxième branche 15 pour recevoir l'autre extrémité 7 avec la possibilité de la déplacer et de l'extraire complètement et une troisième branche 16, perpendiculaire aux précédentes, et qui reçoit les fils d'entrée 11 et de sortie 12.

La troisième branche 16 comprend encore une sonde de température 18 et un dispositif de paramétrage 19 à mémoire, contenant les paramètres de calibration du capteur 4 et son numéro de série, qui permettent de corréler le courant induit dans le bobinage 10 par un courant circulant par le conducteur autour duquel le capteur est bouclé et qui ont été obtenus par des étalonnages préliminaires. La troisième branche 16 finit sur une broche de connexion électrique 20 comprenant des connexions 22 au fil d'entrée 11, 23 au fil de sortie 12 et 24 aux dispositifs 18 et 19. Un dispositif de commande (41 sur d'autres figures) connecté à la branche 20 permet de recueillir le courant passant par le bobinage 10 et d'exploiter les dispositifs 18 et 19. Il peut aussi injecter de petites quantités de courant dans le câble 5 pour vérifier périodiquement sa continuité. Du fait de l'amplitude faible du signal de sortie du capteur, soit quelques dizaines de millivolts par kiloampère, le dispositif de commande est monté de préférence à proximité, soit au plus quelques mètres. D'autre part, le câble de liaison comporte un écran externe destiné à protéger le signal contre les perturbations électromagnétiques; et les deux paires de fils qu'il contient, menant aux connexions 21 à 24, sont torsadées individuellement. Le dispositif de commande amplifie et traite le signal de sortie du capteur en fonction du besoin. Il autorise également une correction de ce signal en fonction des paramètres de la sonde de température 18 et des paramètres d'étalonnage du dispositif 19.

Conformément à l'invention, le manchon 13 est traversé complètement à l'endroit de la première branche 14 et de la deuxième branche 15 par un perçage 54, les extrémités 6 et 7 du câble 5 sont ouvertes c'est-à-dire dépourvues d'embout, et le bobinage 10 affleure sur des surfaces extrêmes 25, qui sont droites (planes, ou sans relief) et peuvent donc être aboutées l'une sur l'autre quelque part dans le perçage 54 en poussant suffisamment l'extrémité 7 dans la deuxième branche 15. Le raccord 13, pourvu d'un évidement 54 le traversant de part en part dans la première branche 14 et la deuxième branche 15, et qui est parfaitement cylindrique, permet le contact des extrémités 6 et 7. Le bobinage 10 s'étend alors sur une circonférence presque continue qui assure une mesure précise. Le réglage impliquant seulement une mise en butée du câble 5 par ce contact, il est facile à établir de façon sûre. Aucune vérification ou aucune recalibration n'est nécessaire. Il est assez souple pour pouvoir être plié dans le perçage 35 et introduit dans la gorge 32 de l'extérieur ; et le perçage 35 est assez large à l'intérieur pour que l'introduction du manchon 13 et la fermeture de la boucle du câble 5 soient aussi faciles.

Selon d'autres dispositions importantes, le manchon 13 est muni de deux bagues de blocage 42 et 43 du câble 5 en translation, dans la première branche 14 et la deuxième branche 15 où elles sont retenues dans des gorges. Les bagues de blocage 42 et 43 comprennent chacune une portion conique 44 dégagée et frottant sur la gaine externe 8 des extrémités 6 et 7 et dirigées l'une vers l'autre, de sorte que l'introduction des extrémités 6 et 7 dans le manchon 13 est facile grâce à une déformation élastique de la portion conique 44 mais leur extraction est empêchée par un arc-boutement de celle-ci. La fermeture du câble 5 est ainsi maintenue en toutes circonstances, sauf quand un poussoir 45, établi dans la deuxième branche 15, est mis en mouvement. Il comprend une portion extérieure 46, dépassant hors du manchon 13 mobile et servant à la préhension, un ergot 47 mobile dans une rainure 48 creusée dans le manchon 13 avec une extension finie, et une pointe 49 dirigée vers la portion conique 44 de la bague de blocage 43. En poussant sur la portion extérieure 46, on enfonce le poussoir 45 et la pointe 49 repousse la portion conique en la déformant élastiquement et la dégageant de l'extrémité 7, qui peut alors être retirée pour ouvrir la boucle du câble 5. Dans la portion normale, représentée à la figure 3, le poussoir 45 est toutefois séparé de la bague de blocage 43. La longueur et la position de la rainure 47 sont choisies pour autoriser ces deux états. La première branche 14 du manchon 13 peut être dépourvue de poussoir, l'extrémité 6 y étant logée de façon permanente. Le manchon 13 comprend encore deux joints d'étanchéité circulaires 50 et 51 dans deux autres rainures des branches 14 et 15 pour enserrer les extrémités 6 et 7 du câble 5 et établir une étanchéité de sa jonction ; la troisième branche 16 est elle-même isolée par un troisième joint 52 que l'embout 20 comprime sur elle.

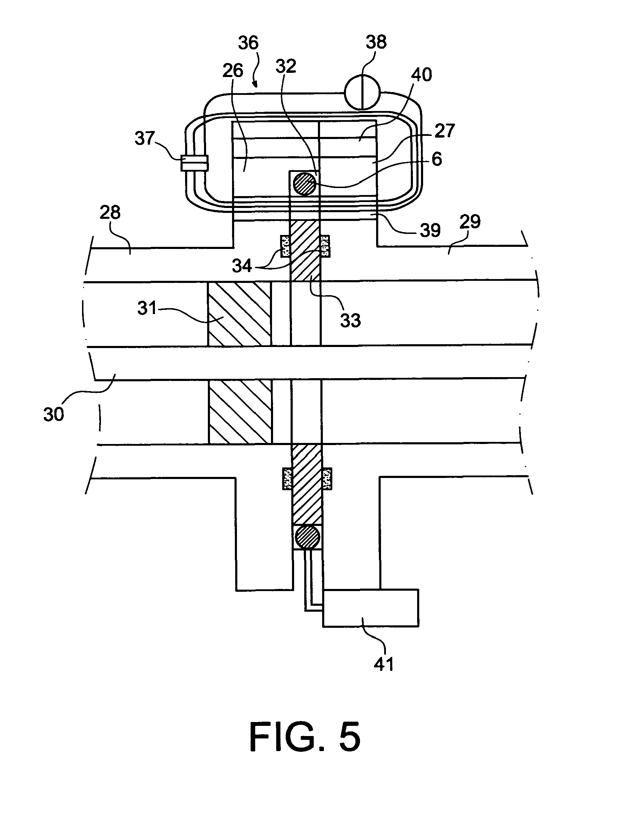

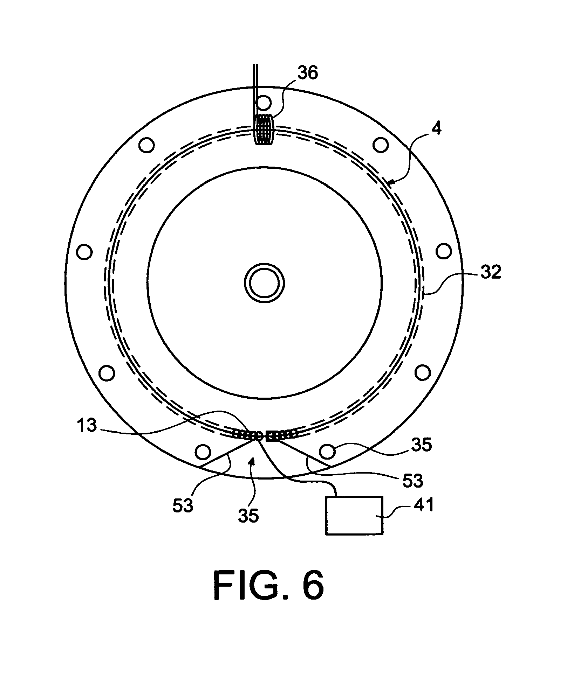

Les figures 5 et 6 illustrent l'utilisation du capteur 4 avec un câble électrique blindé et à isolation gazeuse. Le capteur 4 est ici disposé entre les brides de jonction 26 et 27 de deux tronçons 28 et 29 d'enveloppe du câble 30 électrique à surveiller, qui s'étend au centre des tronçons 28 et 29 en étant soutenu par des isolateurs 31. Le capteur 4 s'étend dans une gorge 32 circulaire et continue d'une des brides 26, autour d'un flasque isolant 33 complété par des joints d'étanchéité aux gaz 34. Le dispositif de commande 41 du capteur 4 est représenté fixé à l'autre bride 25. Avantageusement, la gorge 32 est circonscrite par des perçages des boulons 40 afin que ceux-ci n'altèrent pas la mesure.

L'élément essentiel de cette réalisation est que la gorge 32 communique à l'extérieur seulement par une ouverture 35 en éventail, par laquelle le capteur 4 peut être introduit en commençant par l'extrémité 6. Le câble 5 progresse ainsi dans la gorge 32 en s'enroulant peu à peu, et forme naturellement une boucle quand le raccord 13 a été enfoncé dans la gorge 32. Les bords 53 de l'ouverture 35 sont en effet assez proches de la tangente avec la gorge 32, et le câble 5 est assez souple pour pouvoir être plié dans le perçage 35 et introduit dans la gorge 32 de l'extérieur ; et l'ouverture 35 est assez large à l'intérieur pour que l'introduction du manchon 13 et la fermeture de la boucle du câble 5 soient aussi faciles. Cette disposition permet de ne pas démonter l'enveloppe du câble 30 quand une manipulation sur le capteur 4 est nécessaire.

Une autre disposition concerne un bobinage de test 36 autonome qui peut être utilisé pour le test du capteur 4 en injectant un courant qui s'ajoute au courant primaire. Ce bobinage de test 36, peu intrusif, ne nécessite pas de démontage. Il peut être un câble ouvert pouvant être bouclé à une jonction 37, composé d'un certain nombre de spires et alimenté par un générateur de courant 38. Il passe par un perçage 39 établi à travers les brides 26 et 27 entre le flasque 33 et le capteur 4. L'autre côté passe à l'extérieur des brides 26 et 27 pour entourer une section du capteur 4.

## Revendications

1. Capteur de courant (4) sous forme d'un câble (5) à attacher en boucle autour d'un élément conducteur (30) à surveiller en joignant des extrémités (6,7) du câble (5), le câble comprenant une gaine (8,9) et un bobinage (10) transformateur logé dans la gaine, et le capteur comprenant un manchon (13) à perçage (54) de réception et de raccordement des extrémités (6,7) du câble (5), **caractérisé en ce que** le manchon de raccordement contient une mémoire électronique (19) contenant des paramètres de calibration du capteur et, dans le perçage (54), un dispositif de fermeture et d'ouverture comportant une bague circulaire déformable (43) assurant soit le maintien en boucle fermée du câble, soit une ouverture de la boucle grâce à un poussoir (45) externe apte à presser sur la bague, enserrant puis dégageant une des extrémités (7), mobile, du câble.

2. Capteur de courant selon la revendication 1, **caractérisé en ce que** le perçage (54) traverse complètement le manchon (13), le bobinage (10) affleure à des surfaces extrêmes (25) planes des extrémités du câble, permettant un aboutement spire contre spire des extrémités droites du câble.

3. Capteur de courant selon l'une quelconque des revendications 1 ou 2, **caractérisé en ce que** la bague a une portion conique (44), pour enserrer l'extrémité du câble.

4. Capteur de courant selon l'une quelconque des revendications 1 à 3, **caractérisé en ce qu'**il comprend une autre bague circulaire déformable (42) assurant un maintien, en l'enserrant, d'une autre des extrémités (6), fixe du câble.

5. Capteur de courant selon l'une quelconque des revendications 1 à 4, **caractérisé en ce que** le manchon (13) comprend des joints (50, 51) d'étanchéité autour des extrémités du câble (5).

6. Capteur de courant selon l'une quelconque des revendications 1 à 5, **caractérisé en ce que** la gaine comprend une couche extérieure (8) en polyuréthane, une couche intérieure (9) soit en polyuréthane soit en polyamide, et le bobinage (10) est encastré entre les deux couches (8,9).

7. Capteur de courant selon l'une quelconque des revendications 1 ou 2, **caractérisé en ce qu'**il comprend un capteur de température (18).

8. Capteur de courant selon l'une quelconque des revendications 3 à 5, **caractérisé en ce que** l'un au moins parmi le capteur de température (18) et le dispositif de paramétrage (19) est logé dans une branche (16) du manchon (13) destinée à une commande (41) électrique extérieure, et perpendiculaire à deux autres branches (14,15) du manchon qui reçoivent les extrémités (6,7) du câble (5).

9. Appareillage électrique comprenant un capteur de courant selon l'une quelconque des revendications précédentes, **caractérisé en ce qu'**il comporte une gorge (32) circulaire interne, communiquant à l'extérieur par une ouverture (35) s'évasant vers l'extérieur.

10. Appareillage électrique selon la revendication 9, **caractérisé en ce qu'**il comporte un bobinage (36) de test du capteur de courant (4), qui est logé autour d'une portion de la gorge, partiellement dans un perçage (39) de l'appareillage.

11. Application du capteur de courant selon l'une quelconque des revendications 1 à 8 à la surveillance d'un poste électrique à isolation gazeuse (3).

12. Application du capteur de courant selon l'une quelconque des revendications 1 à 8 à la surveillance d'une traversée aérienne (1) vers une ligne aérienne de courant.

## Patentansprüche

1. Stromsensor (4) in Form eines Kabels (5), das als Schleife um ein zu überprüfendes leitfähiges Element (30) herum zu befestigen ist, indem die Enden (6, 7) des Kabels (5) zusammengefügt werden, wobei das Kabel einen Mantel (8, 9) und eine Transformatorwicklung (10) enthält, die in dem Mantel aufgenommen ist, und wobei der Sensor eine Muffe (13) mit einer Bohrung (54) zum Aufnehmen und Verbinden der Enden (6, 7) des Kabels (5) aufweist, **dadurch gekennzeichnet, dass** die Verbindungsmuffe einen elektronischen Speicher (19) enthält, der Kalibrierparameter zum Kalibrieren des Sensors enthält, sowie in der Bohrung (54) eine Schließ- und Öffnungsvorrichtung mit einem verformbaren, kreisrunden Ring (43), der entweder den Halt des Kabels in geschlossener Schleife oder ein Öffnen der Schleife über einen äußeren Schieber (45), der geeignet ist, auf den Ring zu drücken, gewährleistet und eines der Kabelenden (7), das beweglich ist, einspannt und dann freigibt.

2. Stromsensor nach Anspruch 1, **dadurch gekennzeichnet, dass** die Bohrung (54) die Muffe (13) vollständig durchsetzt, wobei die Wicklung (10) bündig mit ebenen Außenflächen (25) der Kabelenden ist und so eine Aneinanderfügung der geraden Kabelenden Windung an Windung gestattet.

3. Stromsensor nach einem der Ansprüche 1 oder 2, **dadurch gekennzeichnet, dass** der Ring einen konisch verlaufenden Abschnitt (44) aufweist, um das Kabelende einzuspannen.

4. Stromsensor nach einem der Ansprüche 1 bis 3, **dadurch gekennzeichnet, dass** er einen weiteren verformbaren, kreisrunden Ring (42) aufweist, der einen Haft des anderen Endes (6), das fest am Kabel angeordnet ist, durch Einspannen gewährleistet.

5. Stromsensor nach einem der Ansprüche 1 bis 4, **dadurch gekennzeichnet, dass** die Muffe (13) Dichtungen (50, 51) um die Enden des Kabels (5) herum aufweist.

6. Stromsensor nach einem der Ansprüche 1 bis 5, **dadurch gekennzeichnet, dass** der Mantel eine äußere Lage (8) aus Polyurethan, eine innere Lage (9) entweder aus Polyurethan oder aus Polyamid aufweist und die Wicklung (10) zwischen den beiden Lagen (8, 9) eingefügt ist.

7. Stromsensor nach einem der Ansprüche 1 oder 2, **dadurch gekennzeichnet, dass** er einen Temperaturmeßfühler (18) aufweist.

8. Stromsensor nach einem der Ansprüche 3 bis 5, **dadurch gekennzeichnet, dass** zumindest eines der Bauteile, Temperaturmeßfühler (18) oder Parametriervorrichtung (19), in einem Zweig (16) der Muffe (13) aufgenommen ist, der für eine elektrische Steuerung (41) von außen bestimmt ist, und senkrecht zu zwei weiteren Zweigen (14, 15) der Muffe verläuft, welche die Enden (6, 7) des Kabels (5) aufnehmen.

9. Elektrische Einrichtung mit einem Stromsensor nach einem der vorangehenden Ansprüche, **dadurch gekennzeichnet, dass** sie eine innere, kreisrunde Nut (32) aufweist, die über eine sich nach außen erweiternde Öffnung (35) mit dem Außenbereich kommuniziert.

10. Elektrische Einrichtung nach Anspruch 9, **dadurch gekennzeichnet, dass** sie eine Testwicklung (36) zum Testen des Stromsensors (4) aufweist, die um einen Abschnitt der Nut herum teilweise in einer Bohrung (39) der Einrichtung aufgenommen ist.

11. Anwendung des Stromsensors nach einem der Ansprüche 1 bis 8 zum Überprüfen einer gasisolierten, elektrischen Anlage (3).

12. Anwendung des Stromsensors nach einem der Ansprüche 1 bis 8 zum Überprüfen einer Leitungsüberquerung (1) zu einer oberirdischen Stromleitung.

## Claims

1. A current sensor (4) consisting of a cable (5) for attachment in the form of a loop around a conductor element (30) to be monitored by conjoining the two end portions (6, 7) of the cable (5), the cable including a sheath (8, 9) and a transformer winding (10) arranged in the sheath, and the sensor further including a sleeve (13) having a bore (54) for receiving and conjoining the end portions (6, 7) of the cable (5), the sensor being **characterized in that** the conjunction sleeve contains an electronic calibration memory (19) that contains calibration parameters for the sensor, and, in the bore (54), a closing and opening device comprising a deformable circular stop ring (43) for selectively ensuring that the cable is held as a closed loop and enabling the loop to be opened in response to an external push button (45) adapted to press on the stop ring, whereby to grip and then release one of the end portions of the cable, which is a movable end portion (7).

2. A current sensor according to claim 1, **characterized in that** the bore (54) extends through the whole of the sleeve (13), the winding (10) being flush with the flat end faces (25) of the end portions of the cable whereby to enable the straight end portions of the cable to abut with each other, turn against turn.

3. A current sensor according to claim 1 or claim 2, **characterized in that** the stop ring has a conical portion (44) for bearing grippingly on the end portion of the cable.

4. A current sensor according to any one of claims 1 to 3, **characterized in that** it also includes a further deformable circular stop ring (42) for ensuring that the other end portion of the cable, which is a stationery end portion (6), is held by bearing grippingly on said stationary end portion.

5. A current sensor according to any one of claims 1 to 4, **characterized in that** the sleeve (13) has sealing rings (50, 51) around the end portions of the cable (5).

6. A current sensor according to any one of claims 1 to 5, **characterized in that** the sheath comprises an outer layer (8) of polyurethane and an inner layer (9) of ether polyurethane or polyamide, and the winding (10) is embedded between the two said layers (8, 9).

7. A current sensor according to claim 1 or claim 2, **characterized in that** it includes a temperature sensor (18).

8. A current sensor according to any one of claims 3 to 5, **characterized in that** at least one of the group consisting of the temperature sensor (18) and the calibration memory (19) is disposed in a branch (16) of the sleeve (13) that is adapted for connection to an external electrical control unit (41) and that is perpendicular to two further branches (14, 15) of the sleeve that receive the end portions (6, 7) of the cable (5).

9. Electrical apparatus adapted to include a current sensor according to any preceding claim, **characterized in that** it has a circular internal groove (32) that communicates with the outside through an aperture (35) that is divergent outwards.

10. Electrical apparatus according to claim 9, **characterized in that** it includes a test winding (36) for testing the current sensor (4), the test winding being arranged around a portion of the groove, partly in a hole (39) of the apparatus.

11. The application of the current sensor according to any one of claims 1 to 8 to the monitoring of a gas insulated substation (3).

12. The application of a current sensor according to any one of claims 1 to 8 to the monitoring of an outdoor bushing (1) leading to an overhead power line.
